# EUROPEAN PATENT SPECIFICATION

(11) **EP 1 712 822 B1**
(45) Date of publication and mention of the grant of the patent: **05.12.2007**
(21) Application number: 06007596.7
(22) Date of filing: 11.04.2006
(51) Int. Cl.: F16K 51/02, F16K 31/528

(54) **Gate valve apparatus for vacuum processing system**
Schieber für Vakuumbehandlungseinrichtung
Vanne pour système de traitement sous vide

(30) Priority: 12.04.2005 JP 2005115111
(43) Date of publication of application: 18.10.2006
(73) Proprietor: TOKYO ELECTRON LIMITED, Minato-ku Tokyo 107-8481 (JP)
(72) Inventor: Hiroki, Tsutomu Tokyo Electron Limited, Tokyo 107-8481 (JP)
(74) Representative: HOFFMANN EITLE

(56) References cited:
- EP-A- 0 684 415
- WO-A-02/05322
- US-A- 6 089 537
- US-B1- 6 206 029
- US-B1- 6 494 434

## Description

The present invention relates to a gate valve apparatus for a vacuum processing system and a semiconductor processing system including a plurality of process chambers. The term "semiconductor process" used herein includes various kinds of processes which are performed to manufacture a semiconductor device or a structure having wiring layers, electrodes, and the like to be connected to a semiconductor device, on a target object, such as a semiconductor wafer or a glass substrate used for an LCD (Liquid Crystal Display) or FPD (Flat Panel Display), by forming semiconductor layers, insulating layers, and conductive layers in predetermined patterns on the target object.

In general, in manufacturing semiconductor devices, various processes, such as dry etching, sputtering, and CVD (Chemical Vapor Deposition), are repeatedly performed on a semiconductor wafer. Most of these processes are performed in a vacuum atmosphere within process chambers. The process chambers have transfer ports for transferring the wafer, which are airtightly closed by gate valve apparatuses during the processes.

Patent Document 1 (Jpn. Pat. Appln. KOKAI Publication No. 8-60374), for example, discloses a gate valve apparatus according to the preamble of claim 1, and a semiconductor processing system according to the preamble of claim 20. For example, a transfer port is formed in a sidewall of a process chamber that can be vacuum-exhausted, and has a size to allow a wafer to pass therethrough. The transfer port is provided with a gate valve apparatus. During a process, the transfer port is airtightly closed by the valve body of the gate valve apparatus with, e.g., an O-ring interposed therebetween.

In conventional gate valve apparatuses, the structures of an elevating mechanism for moving a valve body up and down and a pushing mechanism for pushing the valve body against a transfer port are complicated and bulky. Consequently, they require a high equipment cost and a large installation space, and entail problems in reliability due to the complexity of the structure.

An object of the present invention is to provide a gate valve apparatus for a vacuum processing system, which has a simple structure to realize a smaller size and a lower cost, while maintaining high reliability in operation.

According to a first aspect of the present invention, there is provided a gate valve apparatus to be provided for a transfer port through which a target object passes in a vacuum processing system, the apparatus comprising:
a valve body configured to open and close the transfer port and to be moved close to and away from the transfer port by reciprocation movement of the valve body in a first direction;
a support rod connected to the valve body and extending in the first direction; and
a driving mechanism configured to drive the valve body through the support rod,
wherein the driving mechanism comprises
a movable shaft structure extending in a second direction substantially perpendicular to the first direction and configured to be reciprocated in the second direction,
a first cam structure coupling the movable shaft structure to the support rod, and including a portion configured to convert reciprocation movement of the movable shaft structure in the second direction into reciprocation movement of the support rod in the first direction, and
a swing drive configured to swing the support rod and the valve body about a central axis of the movable shaft structure as a center.

According to a second aspect of the present invention, there is provided a semiconductor processing system comprising:
a pressure-adjustable common transfer chamber having a plurality of side surfaces;
pressure-adjustable first and second process chambers connected to two of the plurality of side surfaces and each configured to perform a semiconductor process on a target object;
a transfer mechanism disposed inside the common transfer chamber to transfer the target object into and from the first and second process chambers; and
gate valve apparatuses respectively disposed between the common transfer chamber and the first process chamber and between the common transfer chamber and the second process chamber,
wherein each of the gate valve apparatuses comprises
a valve body configured to open and close a transfer port through which the target object passes, and to be moved close to and away from the transfer port by reciprocation movement of the valve body in a first direction,
a support rod connected to the valve body and extending in the first direction, and
a driving mechanism configured to drive the valve body through the support rod, and
wherein the driving mechanism comprises
a movable shaft structure extending in a second direction substantially perpendicular to the first direction and configured to be reciprocated in the second direction,
a first cam structure coupling the movable shaft structure to the support rod, and including a portion configured to convert reciprocation movement of the movable shaft structure in the second direction into reciprocation movement of the support rod in the first direction, and
a swing drive configured to swing the support rod and the valve body about a central axis of the movable shaft structure as a center.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a plan view showing a processing system using gate valve apparatuses according to an embodiment of the present invention;
FIG. 2 is an enlarged sectional view showing a gate valve apparatus according to an embodiment of the invention;
FIG. 3 is a top view of the gate valve apparatus shown in FIG. 2;
FIG. 4 is a perspective view of the gate valve apparatus shown in FIG. 2;
FIG. 5 is sectional view showing a driving mechanism used in the gate valve apparatus shown in FIG. 2;
FIG. 6 is a perspective partial view showing the relationship between a valve body and a support rod in the gate valve apparatus shown in FIG. 2;
FIG. 7 is a perspective view showing a movable shaft structure used in the driving mechanism shown in FIG. 5;
FIGS. 8A and 8B are a side view and a top view, respectively, showing a hollow shaft (outer shaft) used in the driving mechanism shown in FIG. 5;
FIG. 9A is a sectional side view showing a spline shaft (inner shaft) used in the driving mechanism shown in FIG. 5, and FIG. 9B is a sectional end view taken along line A-A in FIG. 9A;
FIGS. 10A, 10B, and 10C are perspective views showing rotation of the spline shaft used in the driving mechanism shown in FIG. 5;
FIG. 11 is a perspective view showing the relationship of the support rod with the movable shaft structure of the driving mechanism shown in FIG. 5;
FIG. 12 is a perspective view showing the relationship of the support rod with the cylinder of the driving mechanism shown in FIG. 5;
FIGS. 13A, 13B, and 13C are perspective views schematically showing a manner of driving the valve body by the driving mechanism shown in FIG. 5;
FIGS. 14A, 14B, 14C, and 14D are diagrams showing a manner of driving the valve body by the driving mechanism shown in FIG. 5; and
FIG. 15 is an enlarged view showing the distal end shape of a slanted guide of a cam slot used in the driving mechanism shown in FIG. 5.

An embodiment of the present invention will now be described with reference to the accompanying drawings. In the following description, the constituent elements having substantially the same function and arrangement are denoted by the same reference numerals, and a repetitive description will be made only when necessary.

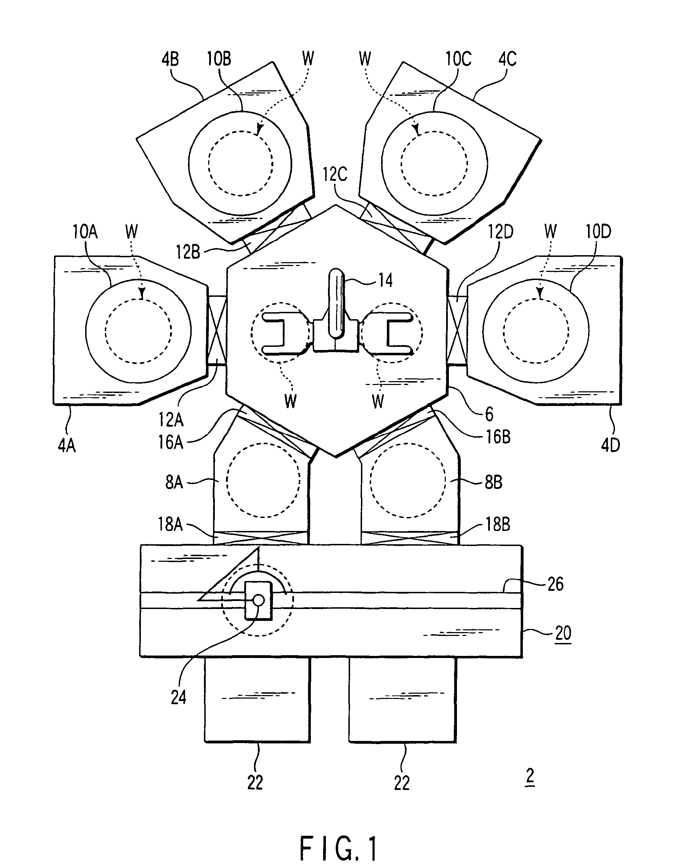

FIG. 1 is a plan view showing a processing system using gate valve apparatuses according to an embodiment of the present invention. As shown in FIG. 1, the processing system 2 includes a hexagonal common transfer chamber 6. Four process chambers 4A, 4B, 4C and 4D and two load-lock chambers 8A and 8B are connected to the common transfer chamber 6.

Specifically, each of the process chambers 4A to 4D is constructed such that the inner pressure thereof is adjustable by gas supply and vacuum-exhaust. The process chambers 4A to 4D include worktables 10A, 10B, 10C, and 10D, respectively, for placing a target object or semiconductor wafer W thereon. While the wafer W is placed on the worktable, various processes are performed. In general, these various processes are performed in a vacuum atmosphere. However, in some cases, the process is performed under atmospheric pressure, depending on the kind of the process. The respective process chambers 4A to 4D are connected to the corresponding sides of the transfer chamber 6 via gate valve apparatuses 12A, 1-2B, 12C and 12D.

The common transfer chamber 6 is also constructed such that the inner pressure thereof is adjustable by gas supply and vacuum-exhaust. A transfer mechanism 14, which is retractable/extendable and is rotatable in order to transfer the wafer W, is disposed within the transfer chamber 6. The transfer mechanism 14 can transfer the wafer W into and from the process chambers 4A to 4D via the gate valve apparatuses 12A to 12D that are opened.

Two load-lock chambers 8A and 8B are connected to the transfer chamber 6 via gate valve apparatuses 16A and 16B. Each of the load-lock chambers 8A and 8B is also constructed such that the inner pressure thereof is adjustable by gas supply and vacuum-exhaust. The load-lock chambers 8A and 8B are connected to a loader module 20 via the gate valve apparatuses 18A and 18B. The loader module 20 is provided with port devices 22 in which cassettes that contain a plurality of wafers W are disposed. A transfer arm mechanism 24, which is retractable/extendable and is rotatable, is disposed within the loader module 20 and movable along a guide rail 26. The transfer arm mechanism 24 can take in a wafer W from the cassette, which is placed in the port device 22, and can transfer it to the load-lock chambers 8A and 8B. The wafer W in the load-lock chamber 8A or 8B is taken in by the transfer mechanism 14 within the transfer chamber 6 and is loaded into the process chambers 4A to 4D, as described above. When the wafer W is to be unloaded, it is transferred through a path in a direction opposite to the direction of loading.

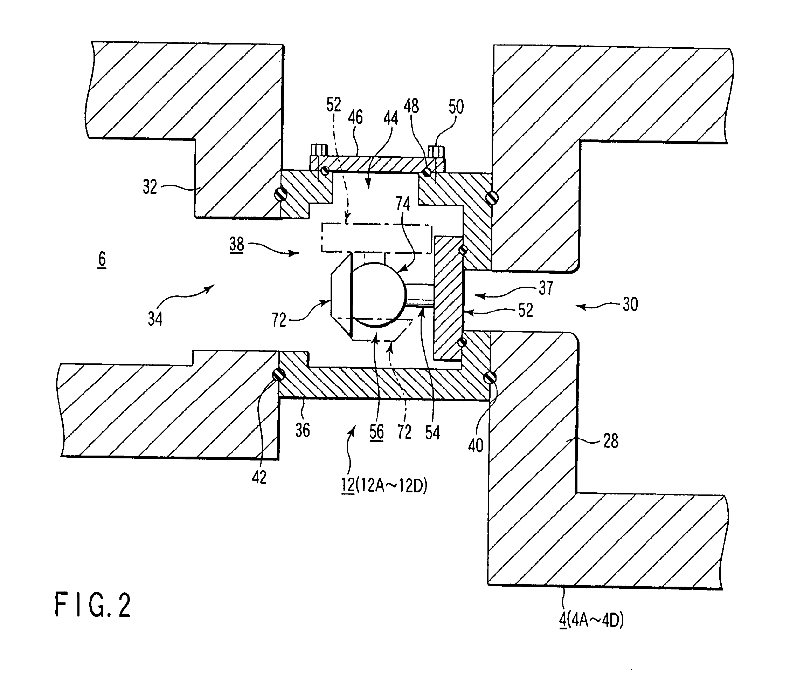

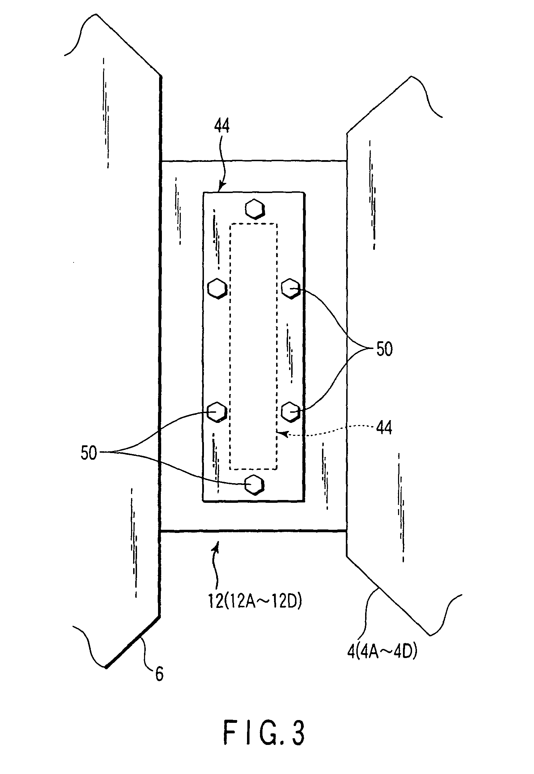

Next, an explanation will be given of the gate valve apparatuses 12A to 12D disposed between the transfer chamber 6 and the process chambers 4A to 4D. Since the gate valve apparatuses 12A to 12D have the same structure, these are representatively referred to as a gate valve apparatus 12, and the process chambers 4A to 4D are representatively referred to as a process chamber 4. FIG. 2 is an enlarged cross-sectional view showing a gate valve apparatus according to an embodiment of the invention. FIG. 3 is a top view of the gate valve apparatus shown in FIG. 2.

As shown in FIG. 2, an elongated port 30, through which the wafer W is transferred, is formed in a sidewall 28 defining the process chamber 4. In addition, a port 34 is formed in a sidewall 32 defining the transfer chamber 6. The gate valve apparatus 12 has a casing 36 that forms an outer shell that defines a transfer space through which the wafer W is passed. The casing 36 is a substantially cubic body formed of, e.g., aluminum, and the casing 36 has a substantially square cross section. An elongated transfer port 37 communicating with the inside of the process chamber 4 is formed on one side of the casing 36. An elongated port 38 communicating with the inside of the transfer chamber 6 is formed on the opposite side of the casing 36. O-rings 40 and 42 are provided at interfaces between the casing 36 and the process chamber 4 and transfer chamber 6 to keep these portions airtight. Within the casing 36, a valve body 52 for airtightly closing the transfer port 37 is attached to a driving mechanism 56. Since the transfer port 37 and transfer port 30 integrally communicate with each other, the transfer port 30 is opened/closed by opening/closing the transfer port 37.

As shown in FIGS. 2 and 3, an elongated maintenance port 44 for performing a maintenance operation, such as cleaning of the valve body 52, is formed in the ceiling of the casing 36. The maintenance port 44 is airtightly closed by a maintenance cover 46 via an O-ring 48. The maintenance cover 46 is attached to the outside of the casing 36. The maintenance cover 46 is detachably attached by a plurality of bolts 50. The maintenance cover 46 may be formed of a transparent plate such as an acrylic resin plate.

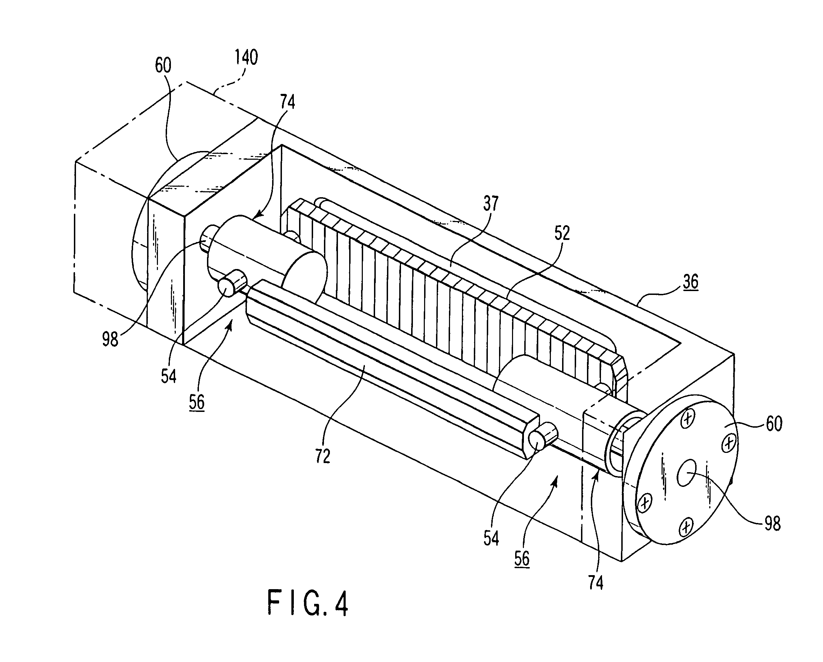

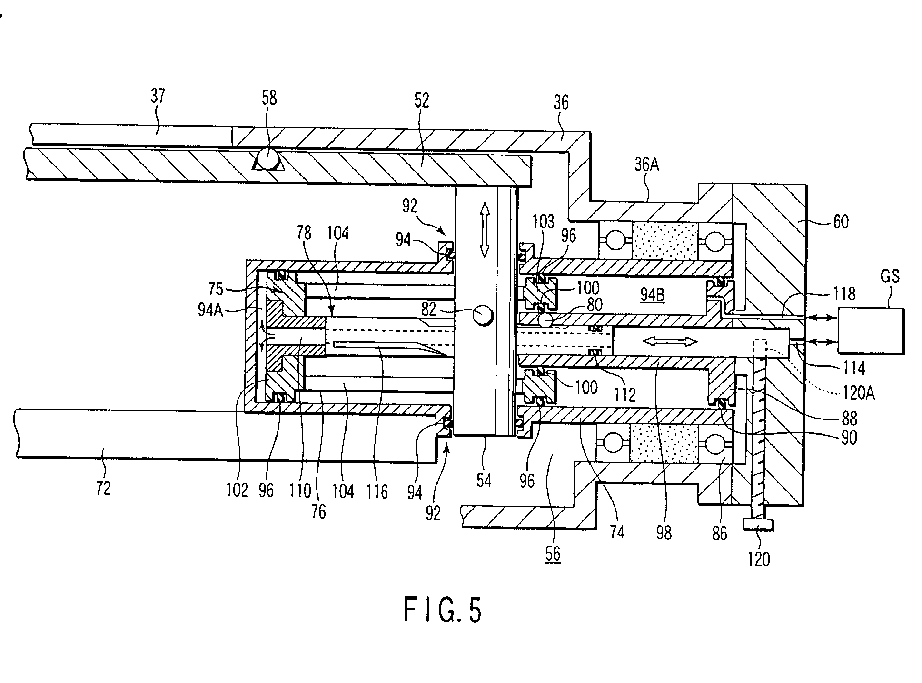

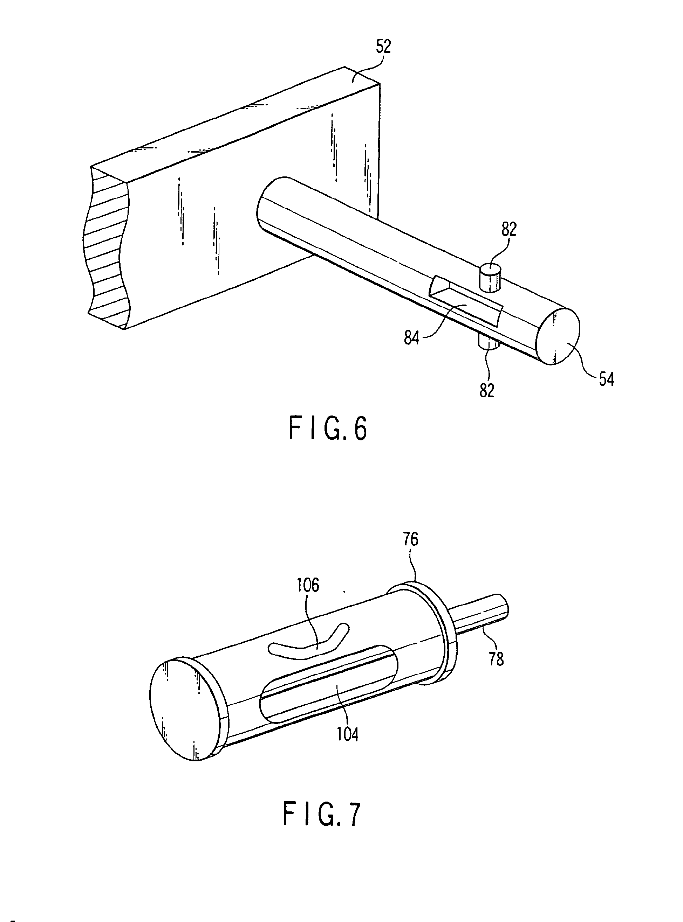

FIG. 4 is a perspective view of the gate valve apparatus 12 shown in FIG. 2. FIG. 5 is sectional view showing the driving mechanism 56 used in the gate valve apparatus 12 shown in FIG. 2. FIG. 6 is a perspective partial view showing the relationship between the valve body 52 and support rod 54 in the gate valve apparatus 12 shown in FIG. 2. As shown in FIGS. 4 and 5, the gate valve apparatus includes a valve body 52 configured to sit on the transfer port 37 to close it and to separate from the transfer port 37 to open it. A support rod 54 is connected near either of the opposite ends of the valve body 52 and extends by a predetermined length in a first direction (a direction in which the valve body 52 is moved close to and away from the transfer port 37). The support rod 54 is coupled to a driving mechanism 56, which includes a movable shaft structure 75 extending and reciprocable in a second direction substantially perpendicular to the first direction. The driving mechanism 56 is configured to convert reciprocation movement of the movable shaft structure 75 in the second direction, in time series, into reciprocation movement of the support rod 54 in the first direction and swing movement of the support rod 54 about the central axis of the movable shaft structure 75 as a center.

The valve body 52 has a rectangular shape corresponding to the shape of the transfer port 37. The front face of the valve body 52 is provided with a seal member 58 formed of, e.g., an O-ring (see FIG. 5) to surround and seal the transfer port 37. The driving mechanism 56 is disposed at each of the opposite ends to correspond to each support rod 54 and is attached to the surrounding wall or casing 36 by an attachment member 60. The movable casings (cylinders 74) of the two driving mechanisms 56 on the right and left sides are connected to each other by a plate-like reinforcing member 72, so that they can integrally rotate.

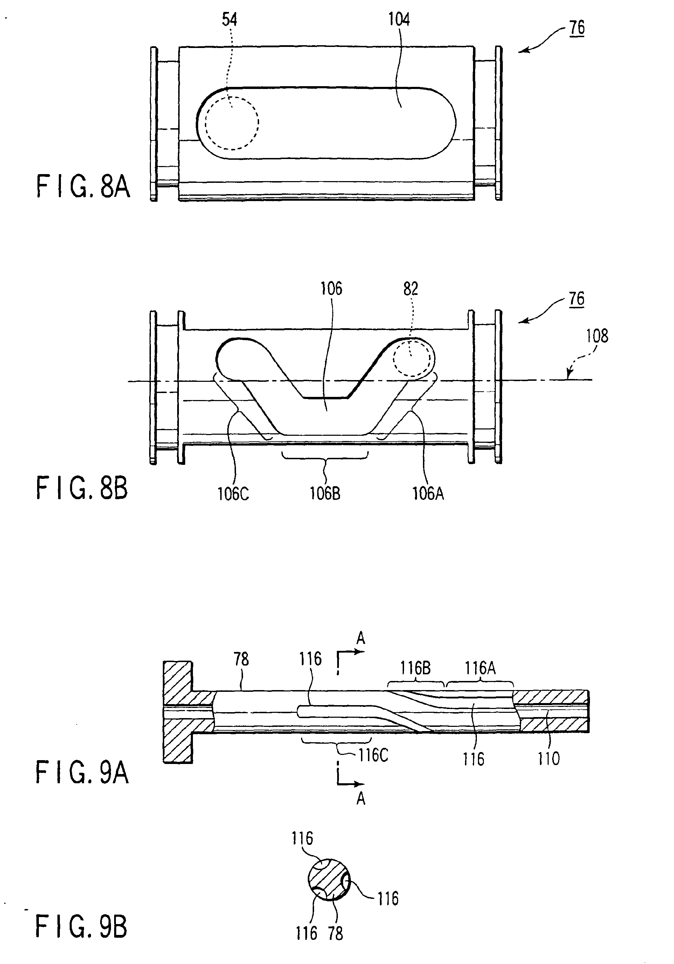

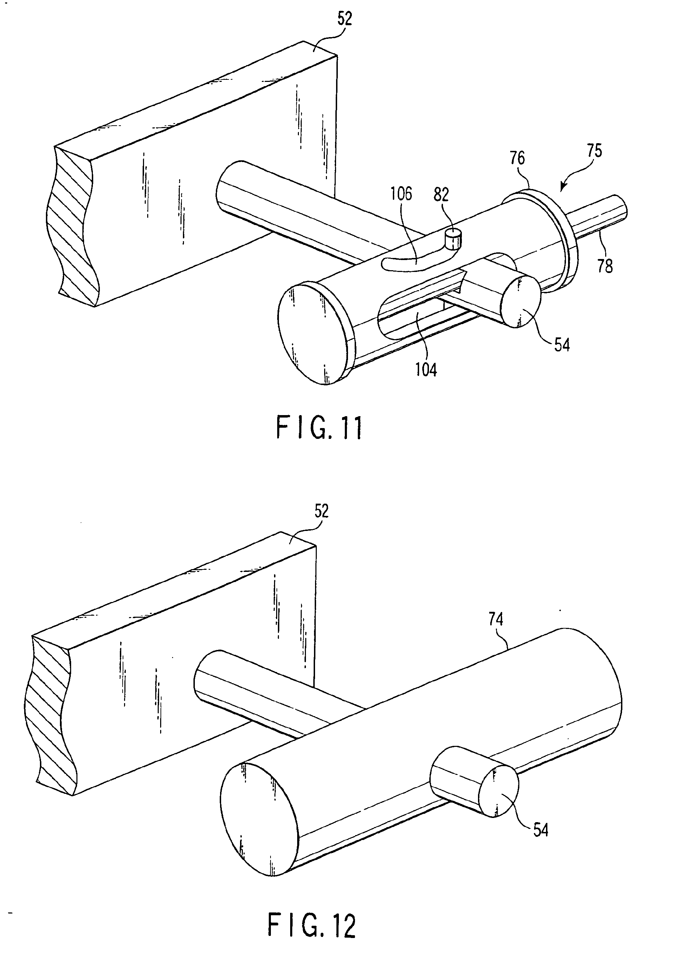

The two driving mechanisms 56 on the right and left sides have the same specific structure except that they are arranged to be symmetrical. Accordingly, only the driving mechanism 56 on the right side in FIG. 4 will be explained below as a representative. FIG. 7 is a perspective view showing the movable shaft structure 75 used in the driving mechanism 56 shown in FIG. 5. FIGS. 8A and 8B are a side view and a top view, respectively, showing a hollow shaft (outer shaft) 76 used in the driving mechanism 56 shown in FIG. 5. FIG. 9A is a sectional side view showing a spline shaft (inner shaft) 78 used in the driving mechanism 56 shown in FIG. 5, and FIG. 9B is a sectional end view taken along line A-A in FIG. 9A. FIG. 11 is a perspective view showing the relationship of the support rod 54 with the movable shaft structure 75 of the driving mechanism 56 shown in FIG. 5. FIG. 12 is a perspective view showing the relationship of the support rod 54 with the cylinder 74 of the driving mechanism 56 shown in FIG. 5.

As shown in FIG. 5, the driving mechanism 56 includes the circular cylinder 74 with the proximal end rotatably supported by the surrounding wall or casing 36 and the movable shaft structure 75 slidably disposed in the cylinder 74. The movable shaft structure 75 comprises a spline shaft (inner shaft) 78 and a hollow shaft (outer shaft) 76 coaxially disposed to integrally reciprocate and rotate. The spline shaft 78 is inserted into an elongated guide tube 98 coaxially disposed in the cylinder 74, so that the spline shaft 78 reciprocates while being guided by the guide tube 98. The hollow shaft 76 has flange portions 102 and 103 (at least one of them serves as a piston head) at the opposite ends, with which the hollow shaft 76 reciprocates while being guided by the inner surface of the cylinder 74.

The support rod 54 has a pair of projections or cam pins (engaging elements) 82 protruding upward and downward at the rod distal end. Each of the cam pins 82 has a small length, so that they can be accommodated in the cylinder 74. The support rod 54 has a long slot 84 penetrating it in the traverse direction. The long slot 84 has a predetermined length, such that the position of the cam pins 82 of the support rod 54 is near the center of the length. The spline shaft 78 is inserted in the long slot 84 with a clearance, and the support rod 54 can move in its axial direction within a range given by the length of the long slot 84 (see

### FIG. 11).

The proximal end of the cylinder 74 is rotatably supported by a flange portion 36A of the casing 36 through a bearing 86 provided with a magnetic fluid seal to keep this portion airtight. The proximal end of the flange portion 36A is fixed to and covered with the attachment member 60 formed of a thick plate. The cylinder 74 has an opening at the proximal end, in which a circular lid member 88 integrated with the attachment member 60 is disposed with a seal member 90 formed of, e.g., an O-ring interposed therebetween, so that they can slide relative to each other. In other words, the seal member 90 allows the cylinder 74 to rotate while keeping the interior of the cylinder 74 airtight. On the other hand, the distal end of the cylinder 74 is closed.

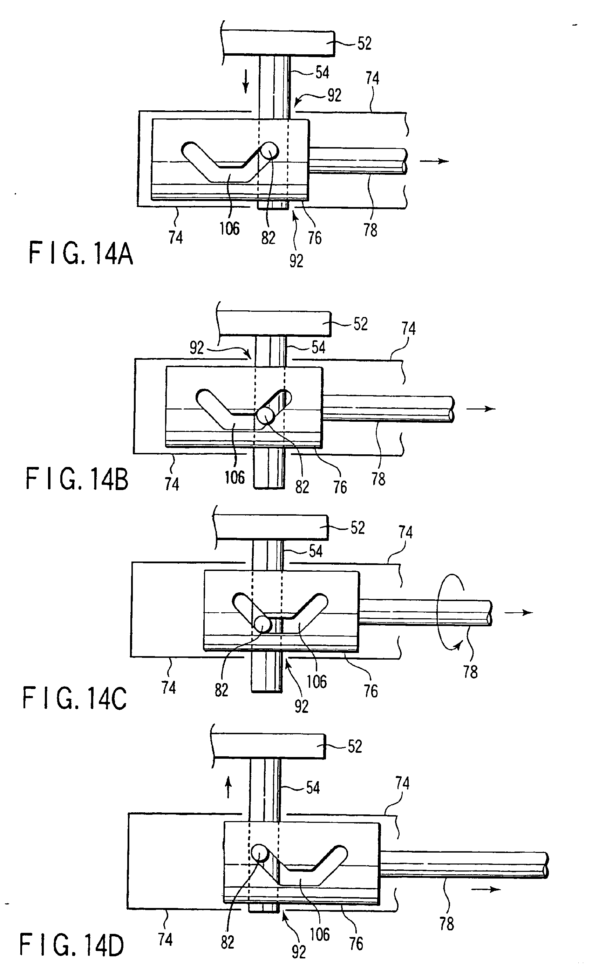

The cylinder 74 has a pair of openings 92 (see FIGS. 5 and 14A to 14D) formed in the sidewall, in which the support rod 54 is slidably inserted. The opening 92 is provided with a seal member 94 formed of, e.g., an O-ring around it, so that the support rod 54 can slide while keeping the interior of the cylinder 74 airtight. The cylinders 74 of the two driving mechanisms 56 disposed for the support rods 54 on the opposite sides of the valve body 52 are connected by the reinforcing member 72.

The hollow shaft 76 of the movable shaft structure 75 is provided with the flange portions 102 and 103 at the opposite ends, which have a diameter slightly larger than the inner portion. The flange portions 102 and 103 are airtightly slidaby disposed in the cylinder 74 with a seal member 96 formed of, e.g., an O-ring interposed therebetween. In order not to hinder movement of the cam pins 82 within the cylinder 74, the ends of the flange portions 102 and 103 are radially further outward than the distal ends of the cam pins 82. The flange portion 103 of the hollow shaft 76 at the proximal end side has an opening, in which the elongated guide tube (base portion) 98 is inserted from the lid member 88 (see FIG. 5). This opening of the flange portion 103 is provided with a seal member 100 formed of, e.g., an O-ring, so that the flange portion 103 can airtightly slide relative to the inserted guide tube 98.

The flange portions 102 and 103 serve as a piston head to divide the interior of the cylinder 74 into two airtight spaces 94A and 94B. As described later, the airtight spaces 94A and 94B are supplied with pressurized air or pressurized nitrogen to drive the movable shaft structure 75 by the piston head. In this embodiment, both the flange portions 102 and 103 serve as a piston head (to airtightly divide the interior of the cylinder), but it suffices if only one of them serves as a piston head.

The hollow shaft 76 has a pair of clearance long slots 104 formed in the sidewall (extending in the horizontal direction in FIG. 5), in which the support rod 54 is inserted with a clearance (see FIG. 8A). The clearance long slot 104 has a predetermined length in the axial direction of the hollow shaft 76, and the hollow shaft 76 can move in its axial direction relative to the support rod 54 within a range given by the length of the long slot 104.

The hollow shaft 76 further has a pair of cam slots 106 formed in the sidewall at positions (on the upper and lower sides in FIG. 11), which are shifted by an angle of 90° from the clearance long slots 104 in the annular direction (see FIG. 8B). Specifically, as shown in FIG. 8B, the cam slot 106 includes two slanted guides 106A and 106C (which are slanted relative to the central axis 108 of the movable shaft structure 75) and a linear guide 106B (which is in parallel with the central axis 108 of the movable shaft structure 75) connecting the slanted guides 106A and 106C, so that they form a U-shape or V-shape. The slanted guide 106A on the right side in FIG. 8B is used for supplying reciprocation movement to the support rod 54 when the valve body 52 is moved close to and away from the transfer port 37. The linear guide 106B on the middle side is used for supplying rotation movement to the support rod 54 when the valve body 52 is rotated upward and downward relative to the transfer port 37. The slanted guide 106C on the left side is used for supplying reciprocation movement to the support rod 54 when the valve body 52 is moved close to and away from the maintenance port 44. If the driving mechanism 56 is not used for moving the valve body 52 to the maintenance port 44, the slanted guide 106C on the left side is unnecessary.

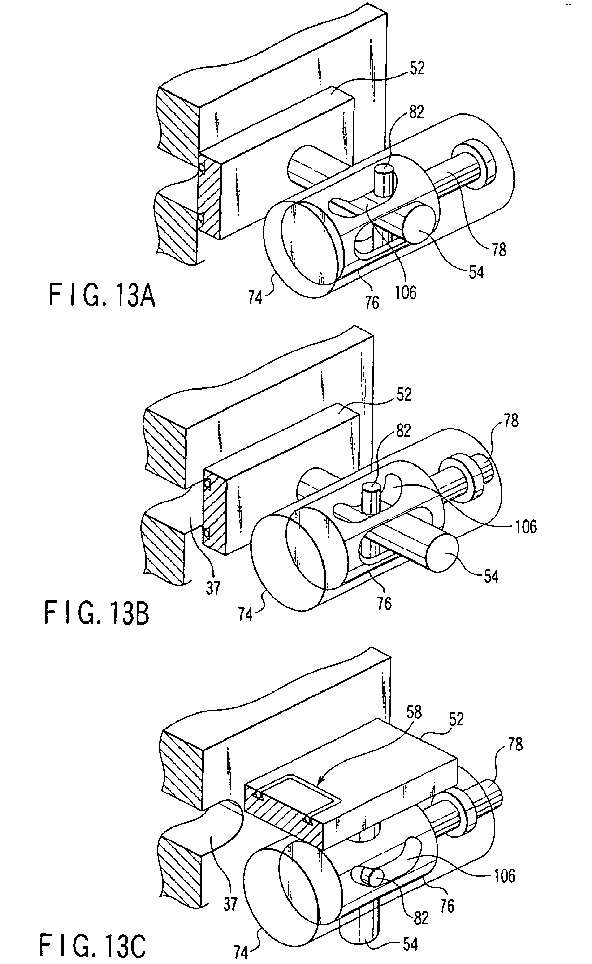

FIGS. 13A, 13B, and 13C are perspective views schematically showing a manner of driving the valve body 52 by the driving mechanism 56 shown in FIG. 5. FIGS. 14A, 14B, 14C, and 14D are diagrams showing a manner of driving the valve body 52 by the driving mechanism 56 shown in FIG. 5. As shown in these figures, when the movable shaft structure 75 is moved in its axial direction, the valve body 52 is moved back and forth and rotated along with the support rod 54. As described above, when the support rod 54 is reciprocated, the slanted guide 106A or 106C engages with the cam pin 82 (see FIGS. 13A and 13C). When the support rod 54 is rotated, the linear guide 106B engages with the cam pin 82 (see FIG. 13B).

The spline shaft 78 shown in FIGS. 9A and 9B is inserted in the hollow shaft 76, and the distal end of the spline shaft 78 is attached and fixed to the flange portion 102 of the hollow shaft 76 on the distal end side. The proximal end of the spline shaft 78 is slidably inserted in the guide tube 98 with the seal member 112 formed of, e.g., an O-ring interposed therebetween. The spline shaft 78 has a gas passage 110 penetrating along the central axis, through which a pressurized gas is supplied into the airtight space 94A on the distal end side. When the pressurized gas is supplied into the airtight space 94A on the distal end side, the movable shaft structure 75 is moved to the right in FIG. 5. On the other hand, when the pressurized gas is supplied into the airtight space 94B on the proximal end side, the movable shaft structure 75 is moved to the left in FIG. 5. FIG. 5 shows a state where the movable shaft structure 75 has been moved to the leftmost position.

A first gas port 114 for supplying and exhausting the pressurized gas to and from the guide tube 98 is formed in the attachment member 60 disposed at the proximal end of the guide tube. The pressurized gas is supplied into and exhausted from the airtight space 94A through the first gas port 114. Further, a second gas port 118 for supplying and exhausting the pressurized gas into and from the other airtight space 94B is formed in the attachment member 60 and lid member 88 (see FIG. 5). A gas charge/discharge unit GS is arranged to supply and exhaust the pressurized gas to and from the first and second gas ports 114 and 118.

The spline shaft 78 has cam grooves 116 formed thereon and extending in its longitudinal direction. The cam grooves 116 comprise a plurality of grooves, e.g., three grooves in the shaft 78 shown in FIGS. 9A and 9B, disposed equidistantly in the annular direction. As shown in FIG. 5, each of the cam grooves 116 engages with a spherical or cylindrical contact element (engaging element) 80, which is rotatably disposed near the distal end of the guide tube 98. The spline shaft 78 is guided by the guide tube 98 in the axial direction to keep the engagement between the contact elements 80 and cam grooves 116.

Specifically, as shown in FIG. 9A, each of the cam grooves 116 includes a slanted guide 116B (which is slanted relative to the central axis 108 of the movable shaft structure 75) at the middle and two linear guides 116A and 116C (which are in parallel with the central axis 108 of the movable shaft structure 75) connected by the slanted guide 116B. The linear guide 116A, slanted guide 116B, and linear guide 116C of the cam groove 116 are arranged to positionally correspond to the slanted guide 106A, linear guide 106B, and slanted guide 106C of the cam slot 106, respectively. Accordingly, the linear guide 116A on the right side in FIG. 9B is used for supplying axial movement to the hollow shaft 76 when the valve body 52 is moved close to and away from the transfer port 37. The slanted guide 116B on the middle side is used for supplying rotation movement to the hollow shaft 76 when the valve body 52 is rotated upward and downward relative to the transfer port 37. The linear guide 116C on the left side is used for supplying axial movement to the hollow shaft 76 when the valve body 52 is moved close to and away from the maintenance port 44. If the driving mechanism 56 is not used for moving the valve body 52 to the maintenance port 44, the linear guide 116C on the left side is unnecessary.

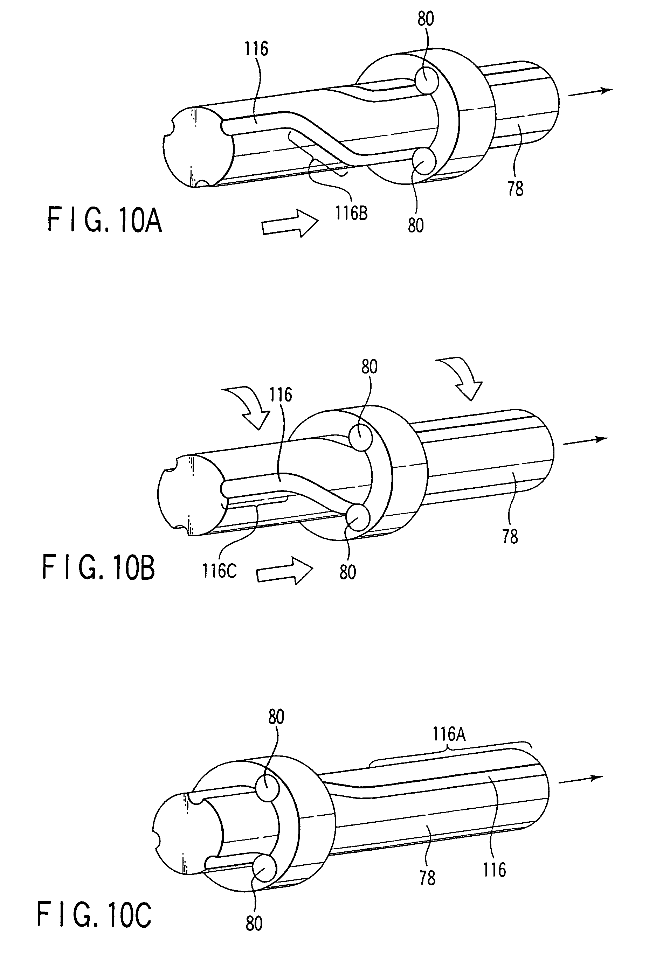

FIGS. 10A, 10B, and 10C are perspective views showing rotation of the spline shaft 78 used in the driving mechanism 56 shown in FIG. 5. As described above, since each of the contact elements 80 is fitted at a predetermined position in the guide tube 98, the contact element 80 is held stationary relative to the cylinder 74. Consequently, when the spline shaft 78 is moved to the right in FIGS. 10A to 10C, within the range where the linear guide 116A or 116C engages with the contact element 80, the spline shaft 78 is moved to the right without rotation. However, within the range where the slanted guide 116B engages with the contact element 80, the spline shaft 78 is moved to the right while being rotated in a certain direction. On the other hand, when the spline shaft 78 is moved to the left, the spline shaft 78 is moved in reverse to those described above.

Back to FIG. 5, the attachment member 60 is provided with a stopper screw 120, whose tip can be projected into and retreated from the hollow portion of the guide tube 98 on the proximal end side, as needed. Except for the time when a maintenance operation is preformed on the valve body 52, the tip of the stopper screw 120 is projected into the hollow portion to prevent the spline shaft 78 from being moved to the right (the deeper side) any more from the state shown in FIG. 5.

Next, an explanation will be given of an operation of the gate valve apparatus 12 having the structure described above.

When a wafer W is not transferred therethrough, such as when a process is performed, the valve body 52 is used to airtightly close the transfer port 37 connected to the process chamber 4 (the state shown with solid lines in FIG. 2). On the other hand, when a wafer W is transferred therethrough into and from the process chamber 4, the valve body 52 is separated from the transfer port 37. Then, the valve body 52 is rotated upward or downward by an angle of 90°, and the wafer W is transferred through the gap between the valve body 52 and reinforcing member 72 in this state. This state is shown with chain lines in FIG. 2, wherein the valve body 52 is rotated upward by 90° in this embodiment. When a maintenance operation is preformed on the valve body 52, the valve body 52 is moved upward form the state shown with the chain lines in FIG. 2, and is brought into airtight contact with the maintenance port 44. Then, the maintenance cover 46 (see FIG. 3) is detached, and the maintenance operation is preformed on the valve body 52.

Next, a detailed explanation will be given of an operation of the gate valve apparatus 12.

The serial movement of the gate valve apparatus 12 described above is performed by reciprocation movement of the movable shaft structure 75 within the cylinder 74 of each of the driving mechanisms 56. At this time, the two driving mechanism 56 disposed on the opposite sides of the valve body 52 are operated in synchronism with each other.

When the movable shaft structure 75 is moved back and forth, a pressurized gas is supplied into the airtight space 94A on the left side or the airtight space 94B on the right side in FIG. 5. When the pressurized gas is supplied into one of the airtight spaces, the pressurized gas in the other airtight space is exhausted, so that the hollow shaft 76 can be smoothly moved. For example, when the pressurized gas is supplied into the airtight space 94A, it is supplied through the first gas port 114 formed in the attachment member 60. This pressurized gas flows through the guide tube 98 and the gas passage 110 formed at the center of the spline shaft 78 into the airtight space 94A. When the pressurized gas is supplied into the airtight space 94B, it is supplied through the second gas port 118. The pressure of the pressurized gas is set at, e.g., about 5 Kg/cm².

FIG. 5 shows a state where the valve body 52 is pushed against the transfer port 37 to close the transfer port 37 (see FIGS. 13A and 14A). At this time, the hollow shaft 76 is present at the leftmost position. In this state, each cam pin 82 of the support rod 54 is present at the rightmost position in the slanted guide 106A (see FIG. 8B) on the right side of the cam slot 106 of the hollow shaft 76. Form this state, the pressurized gas is gradually supplied into the airtight space 94A on the left side, so that the movable shaft structure 75 is gradually moved to the right. Consequently, the valve body 52 is operated, as follows.

At first, the spline shaft 78 is moved in its axial direction while the linear guide 116A (see FIG. 9A) of each cam groove 116 of the spline shaft 78 engages with the contact element 80. Within this range, the spline shaft 78 is moved to the right along with the hollow shaft 76 without rotation. At this time, each cam pin 82 is moved along the slanted guide 106A of the cam slot 106 of the hollow shaft 76. Consequently, the support rod 54 is moved in its axial direction to separate the valve body 52 connected thereto from the transfer port 37, which is thus opened (see FIGS. 13B and 14B). Accordingly, looking at both directions of reciprocation movement of the movable shaft structure 75, within the range where the linear guide 116A of the cam groove 116 engages with the contact element 80 and the slanted guide 106A of the cam slot 106 engages with the cam pin 82, the valve body 52 is moved close to and away from the transfer port 37.

Then, the spline shaft 78 is moved in its axial direction while the slanted guide 116B (see FIG. 9A) of each cam groove 116 of the spline shaft 78 engages with the contact element 80. Within this range, the spline shaft 78 is rotated along with the hollow shaft 76 and cylinder 74 about the central axis of the movable shaft structure 75. During this rotation, the spline shaft 78 is supported by the guide tube 98, and the cylinder 74 is supported by the bearing 86 disposed at the proximal end. At this time, each cam pin 82 is moved along the linear guide 106B of the cam slot 106 of the hollow shaft 76. Consequently, the support rod 54 is rotated by an angle of 90° to swing the valve body 52 connected thereto upward from a position facing the transfer port 37 (to a position facing the maintenance port 44 in this embodiment) (see FIGS. 13C and 14C). Accordingly, looking at both directions of reciprocation movement of the movable shaft structure 75, within the range where the slanted guide 116B of the cam groove 116 engages with the contact element 80 and the linear guide 106B of the cam slot 106 engages with the cam pin 82, the valve body 52 is rotated between the position facing the transfer port 37 and the position facing the maintenance port 44.

As described above, in the state where the valve body 52 has been rotated by an angle of 90° to face upward (the state of the valve body 52 shown with chain lines in FIG. 2), a wafer W is transferred through the gap between the valve body 52 and reinforcing member 72. During the normal running of repeating transfer and process operations of wafers W, the tip of the stopper screw 120 disposed in the attachment member 60 is projected into the guide tube 98, as shown with broken lines 120A in FIG. 5. The tip of the stopper screw 120 thus projected stops the spline shaft 78 from being further moved to the right (the deeper side). Accordingly, the cam pin 82 can be moved back and forth only along the linear guide 106B and slanted guide 106A, so as to cause the valve body 52 to perform the opening/closing operation and 90°-rotation movement continuously in time series. In other words, where the movable shaft structure 75 is reciprocated, the driving force thereof is converted into a pushing force and a rotation force of the valve body 52 in time series.

It should be noted that the bent shape of the cam slot 106 of the hollow shaft 76 does not necessarily have to agree with the bent shape of the cam groove 116 of the spline shaft 78. For example, as long as the valve body 52 does not interfere with the surrounding wall of the casing 36, the shapes of the cam slot 106 and cam groove 116 may be designed such that rotation of the valve body 52 is started while the valve body 52 is being retreated.

Next, an explanation will be given of an operation of the valve body 52 when a maintenance operation is performed.

At this time, the tip of the stopper screw 120 disposed in the attachment member 60 is adjusted to retreat from the guide tube 98, as shown in FIG. 5, to allow the spline shaft 78 to be further moved to the deeper side (to the right in FIG. 5). Form this state, the pressurized gas is gradually supplied in the airtight space 94A on the left side, so that the movable shaft structure 75 is gradually further moved to the right. Consequently, the valve body 52 is operated, as follows.

At first, the spline shaft 78 is moved in its axial direction while the linear guide 116C (see FIG. 9A) of each cam groove 116 of the spline shaft 78 engages with the contact element 80. Within this range, the spline shaft 78 is moved to the right along with the hollow shaft 76 without rotation. At this time, each cam pin 82 is moved along the slanted guide 106C of the cam slot 106 of the hollow shaft 76. Consequently, the support rod 54 is moved in its axial direction to move the valve body 52 connected thereto upward from the state where the valve body 52 faces upward (see FIGS. 13C and 14C), thereby bringing the valve body 52 into airtight contact with the maintenance port 44, which is thus closed (see FIGS. 2 and 14D). Then, the maintenance cover 46 is detached, and the maintenance operation is performed on the valve body 52. Accordingly, looking at both directions of reciprocation movement of the movable shaft structure 75, within the range where the linear guide 116C of the cam groove 116 engages with the contact element 80 and the slanted guide 106C of the cam slot 106 engages with the cam pin 82, the valve body 52 is moved close to and away from the maintenance port 44.

As described above, the driving mechanism 56 is arranged to convert a driving force applied to the movable shaft structure 75 in the axial direction into a pushing force and a rotation force of the valve body 52 in time series. Consequently, the apparatus can be simplified to realize a smaller size and a lower cost, while improving the reliability in operation.

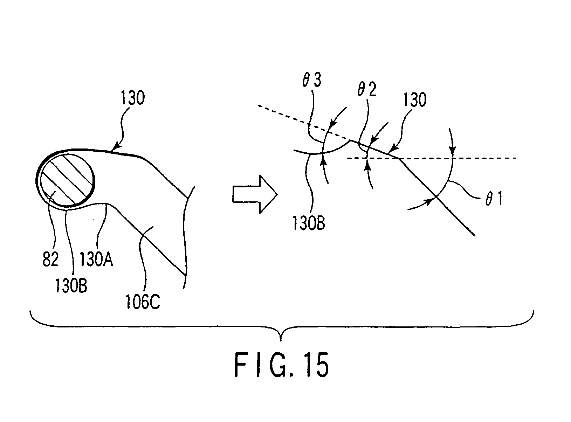

FIG. 15 is an enlarged view showing the distal end shape of a slanted guide 106C of a cam slot 106 used in the driving mechanism 56 shown in FIG. 5, along with the central axis track of the cam slot 106. When the valve body 52 is pushed against the transfer port 37 or maintenance port 44, it is necessary to sufficiently compress the seal member 58, while receiving a repulsive force to thrust back the valve body 52. Accordingly, in order to lock the position of the valve body 52 at this time, the end of each of the slanted guides 106A and 106C of the cam slot 106 has a special shape. Since the shapes of the slanted guides 106A and 106C are symmetric, only the slanted guide 106C will be explained.

Specifically, the distal end 130 of the slanted guide 106, which corresponds to the position for the valve body to close the port, includes a deceleration portion 130A with an inclination angle θ2 smaller that the inclination angle θ1 of the main portion. The length of the deceleration portion 130A is very small, such as, about 1 to 2 mm. At the deceleration portion 130A, the movement distance of the support rod 54 in the pushing direction is reduced relative to the movement distance of the movable shaft structure 75. Consequently, the pushing force applied to the seal member 58 is increased by that much, thereby ensuring the sealing

Further, formed outside the deceleration portion 130A is a lock portion 130B of a small circular arc having an angle θ3 slightly inclined in the inverse direction. The lock portion 130B can lock the cam pin 82 so that it does not slide down along the slanted guide 106. The angle θ3 is set to be small enough for the cam pin 8 to overcome it by slightly compressing the seal member 58 when the valve body 52 is moved in the returning direction. Accordingly, the lock of the cam pin 82 by the lock portion 130B can be easily released by a force in the returning direction.

In the embodiment described above, if the driving mechanism 56 is not used for moving the valve body 52 to the maintenance port 44, the slanted guide 106C on the left side of the cam slot 106 (see FIG. 8B) and the linear guide 116C on the left side of the cam groove 116 (see FIG. 9A) are unnecessary.

In the embodiment described above, the engagement of the cam groove 116 of the spline shaft 78 with the contact element 80 is used for converting the driving force of the movable shaft structure 75 in the axial direction into the rotation movement of the valve body 52. Alternatively, as shown with chain lines in FIG. 4, a rotation drive 140 may be additionally disposed to integrally rotate the entirety of the movable shaft structure 75. Also in this case, as regards reciprocation movement of the valve body 52, the engagement of the cam slot 106 of the hollow shaft 76 with the cam pin 82 is used for converting the driving force of the movable shaft structure 75 in the axial direction into the reciprocation movement of the valve body 52.

For example, in the structure shown in FIG. 5, a rotation drive comprising a motor and gears may be disposed in place of or outside the attachment member 60 to directly or indirectly rotate the cylinder 74 and movable shaft structure 75. In this case, the driving mechanism 56 is only required to have the function of moving the valve body 52 back and forth. The hollow shaft 76 thus only needs to have the slanted guide 106A, without the linear guide 106B and slanted guide 106C. Further, the spline shaft 78 only needs to have the linear guide 116A, without the slanted guide 116B and linear guide 116C.

In the embodiment described above, the cam structure for converting for converting the reciprocation movement of the movable shaft structure 75 in the axial direction into the reciprocation movement of the support rod 54 comprises the combination of the cam slot 106 of the hollow shaft 76 with the cam pin 82 of the support rod 54. Alternatively, a cam structure for the same purpose may comprise a combination of a cam slot formed on the support rod 54 side (e.g., in a member integrated therewith) with a cam pin disposed on the hollow shaft 76 side. Further, in the embodiment described above, the cam structure for converting the reciprocation movement of the movable shaft structure 75 in the axial direction into the rotation movement of the support rod 54 comprises the combination of the cam groove 116 of the spline shaft 78 with the contact element 80 of the guide tube 98. Alternatively, a cam structure for the same purpose may comprise a combination of a cam groove formed on the guide tube 98 side with a contact element disposed on the shaft 78 side.

In the embodiment described above, the target object is exemplified by a semiconductor wafer. Alternatively, the target object may be another substrate, such as a glass substrate, LCD substrate, or ceramic substrate.

## Claims

1. A gate valve apparatus to be provided for a transfer port (37) through which a target object passes in a vacuum processing system, the apparatus comprising:
a valve body (52) configured to open and close the transfer port (37) and to be moved close to and away from the transfer port (37) by reciprocation movement of the valve body (52) in a first direction;
a support rod (54) connected to the valve body (52) and extending in the first direction; and
a driving mechanism (56) configured to drive the valve body (52) through the support rod (54),
**characterized in that** the driving mechanism (56) comprises
a movable shaft structure (75) extending in a second direction substantially perpendicular to the first direction and configured to be reciprocated in the second direction,
a first cam structure (82, 106) coupling the movable shaft structure (75) to the support rod (54), and including a portion (106A) configured to convert reciprocation movement of the movable shaft structure (75) in the second direction into reciprocation movement of the support rod (54) in the first direction, and
a swing drive (80, 116) configured to swing the support rod (54) and the valve body (52) about a central axis of the movable shaft structure (75) as a center.

2. The apparatus according to claim 1, wherein the driving mechanism (56) **characterized by** further comprises:
a piston head (102, 103) connected to the movable shaft structure (75);
a cylinder (74) accommodating the piston head (102, 103) while defining first and second airtight spaces (94A, 94B) one on either side of the piston head (102, 103); and
a mechanism (GS) configured to selectively supply a fluid into the first and second airtight spaces (94A, 94B) to drive the piston head (102, 103).

3. The apparatus according to claim 1, **characterized in that** the first cam structure (82, 106) comprises a first slanted guide (106A) and a first engaging element (82) respectively disposed on one and the other of the movable shaft structure (75) and the support rod (54) to engage with each other, in order to convert reciprocation movement of the movable shaft structure (75) in the second direction into reciprocation movement of the support rod (54) in the first direction, and the first slanted guide (106A) is slanted relative to the central axis of the movable shaft structure (75).

4. The apparatus according to claim 3, **characterized in that** the first slanted guide (106A) comprises a deceleration portion (130A) having a decreased inclination angle at an end corresponding to a position for the valve body (52) to close the transfer port (37).

5. The apparatus according to claim 4, **characterized in that** the first slanted guide (106A) further comprises a lock portion (130B) disposed outside the deceleration portion (130A) and inversely inclined.

6. The apparatus according to claim 1, **characterized in that** the swing drive (80, 116) is configured to convert reciprocation movement of the movable shaft structure (75) in the second direction into swing movement of the support rod (54) and the valve body (52).

7. The apparatus according to claim 6, **characterized in that** the swing drive (80, 116) comprises:
a coupling portion (82, 106B) coupling the support rod (54) to the movable shaft structure (75), and configured to rotate the support rod (54) along with the movable shaft structure (75) about the central axis of the movable shaft structure (75) as a center;
a second cam structure (80, 116) coupling the movable shaft structure (75) to a base portion (98), and including a portion (116B) configured to convert reciprocation movement of the movable shaft structure (75) in the second direction into rotation movement of the movable shaft structure (75) about the central axis of the movable shaft structure (75) as a center.

8. The apparatus according to claim 7, **characterized in that** the second cam structure (80, 116) comprises a second slanted guide (116B) and a second engaging element (80) respectively disposed on one and the other of the base portion (98) and the movable shaft structure (75) to engage with each other, in order to convert reciprocation movement of the movable shaft structure (75) in the second direction into rotation movement of the movable shaft structure (75) about the central axis of the movable shaft structure (75) as a center, and the second slanted guide (116B) is slanted relative to the central axis of the movable shaft structure (75).

9. The apparatus according to claim 8, **characterized in that** the first cam structure (82, 106) comprises a first slanted guide (106A) and a first engaging element (82) respectively disposed on one and the other of the movable shaft structure (75) and the support rod (54) to engage with each other, in order to convert reciprocation movement of the movable shaft structure (75) in the second direction into reciprocation movement of the support rod (54) in the first direction, and the first slanted guide (106A) is slanted relative to the central axis of the movable shaft structure (75), and
wherein the first cam structure (82, 106) comprises a first linear guide (106B) disposed in parallel with the central axis of the movable shaft structure (75) and correspondingly to the second slanted guide (116B), and the second cam structure (80, 116) comprises a second linear guide (116A) disposed in parallel with the central axis of the movable shaft structure (75) and correspondingly to the first slanted guide (106A).

10. The apparatus according to claim 7, **characterized in that** the movable shaft structure (75) comprises an inner shaft (78) and an outer shaft (76) coaxially disposed to integrally perform reciprocation movement and rotation movement,
wherein the first cam structure (82, 106) comprises a first slanted guide (106A) and a first engaging element (82) respectively disposed on one and the other of the outer shaft (76) and the support rod (54) to engage with each other, in order to convert reciprocation movement of the movable shaft structure (75) in the second direction into reciprocation movement of the support rod (54) in the first direction, and the first slanted guide (106A) is slanted relative to the central axis of the movable shaft structure (75), and
wherein the second cam structure (80, 116) comprises a second slanted guide (116B) and a second engaging element (80) respectively disposed on one and the other of the base portion (98) and the inner shaft (78) to engage with each other, in order to convert reciprocation movement of the movable shaft structure (75) in the second direction into rotation movement of the movable shaft structure (75) about the central axis of the movable shaft structure (75) as a center, and the second slanted guide (116B) is slanted relative to the central axis of the movable shaft structure (75).

11. The apparatus according to claim 10,
**characterized in that** the driving mechanism (56) comprises:
a piston head (102, 103) connected to the movable shaft structure (75);
a cylinder (74) accommodating the piston head (102, 103), the inner shaft (78), and the outer shaft (76) while defining first and second airtight spaces (94A, 94B) one on either side of the piston head (102, 103); and
a gas supply mechanism (GS) configured to selectively supply a gas into the first and second airtight spaces (94A, 94B) to drive the piston head (102, 103).

12. The apparatus according to claim 11, **characterized in that** the gas supply mechanism (GS) comprises a gas passage (110) penetrating the inner shaft (78) and the piston head (102, 103) in an axial direction and connected to the first airtight space (94A).

13. The apparatus according to claim 11, **characterized in that** the cylinder (74) is configured to rotate along with the support rod (54) and the movable shaft structure (75) about the central axis of the movable shaft structure (75) as a center.

14. The apparatus according to claim 1, **characterized in that** the support rod (54) comprises first and second portions respectively connected to the valve body (52) near opposite ends thereof, and the driving mechanism (56) comprises first and second portions respectively disposed to correspond to the first and second portions of the support rod (54).

15. The apparatus according to claim 14, **characterized in that** the first and second portion of the driving mechanism (56) are connected to each other by a reinforcing member (72).

16. The apparatus according to claim 1, **characterized in that** the swing drive comprises a rotation drive (140) configured to integrally rotate entirety of the movable shaft structure (75) about the central axis of the movable shaft structure (75) as a center, so as to swing the support rod (54) and the valve body (52).

17. The apparatus according to claim 1, **characterized in that** the vacuum processing system comprises a maintenance port (44), disposed at a position to which the valve body (52) selectively faces within a rotation range of the valve body (52), to perform a maintenance operation on the gate valve apparatus, and
wherein the first cam structure (82, 106) comprises a portion (106C) configured to convert reciprocation movement of the movable shaft structure (75) in the second direction into reciprocation movement of the support rod (54) relative to the maintenance port (44).

18. The apparatus according to claim 17, **characterized in that** the first cam structure (82, 106) comprises a first slanted guide (106A) and a first engaging element (82) respectively disposed on one and the other of the movable shaft structure (75) and the support rod (54) to engage with each other, in order to convert reciprocation movement of the movable shaft structure (75) in the second direction into reciprocation movement of the support rod (54) in the first direction, and the first slanted guide (106A) is slanted relative to the central axis of the movable shaft structure (75), and
wherein the first cam structure (82, 106) further comprises a third slanted guide (106C) connected to the first slanted guide (106A) to engage with the first engaging element (82), in order to convert reciprocation movement of the movable shaft structure (75) in the second direction into reciprocation movement of the support rod (54) relative to the maintenance port (44).

19. The apparatus according to claim 18, **characterized in that** the first and third slanted guides 106A, 106C are disposed to form a U-shape or V-shape.

20. A semiconductor processing system comprising:
a pressure-adjustable common transfer chamber (6) having a plurality of side surfaces;
pressure-adjustable first and second process chambers (4) connected to two of the plurality of side surfaces and each configured to perform a semiconductor process on a target object;
a transfer mechanism disposed inside the common transfer chamber (6) to transfer the target object into and from the first and second process chambers (4); and
gate valve apparatuses (12) respectively disposed between the common transfer chamber (6) and the first process chamber (4) and between the common transfer chamber (6) and the second process chamber (4),
wherein each of the gate valve apparatuses (12) comprises
a valve body (52) configured to open and close a transfer port (37) through which the target object passes, and to be moved close to and away from the transfer port (37) by reciprocation movement of the valve body (52) in a first direction,
a support rod (54) connected to the valve body (52) and extending in the first direction, and
a driving mechanism (56) configured to drive the valve body (52) through the support rod (54), and
**characterized in that** the driving mechanism (56) comprises
a movable shaft structure (75) extending in a second direction substantially perpendicular to the first direction and configured to be reciprocated in the second direction,
a first cam structure (82, 106) coupling the movable shaft structure (75) to the support rod (54), and including a portion (106A) configured to convert reciprocation movement of the movable shaft structure (75) in the second direction into reciprocation movement of the support rod (54) in the first direction, and
a swing drive (80, 116) configured to swing the support rod (54) and the valve body (52) about a central axis of the movable shaft structure (75) as a center.

## Patentansprüche

1. Absperrschiebereinrichtung zum Einsatz bei einer Durchlassöffnung (37), durch welche ein Zielgegenstand zu einem Vakuumbearbeitungssystem hindurchgeht, wobei die Einrichtung aufweist:
einen Schieberkörper (52), der dazu ausgebildet ist, die Durchlassöffnung (37) zu öffnen und zu schließen, und nahe zu der Durchlassöffnung (37) und weg von dieser bewegt werden, durch eine Hin- und Herbewegung des Schieberkörpers (52) in einer ersten Richtung;
eine Halterungsstange (54), die mit dem Schieberkörper (52) verbunden ist, und sich in der ersten Richtung erstreckt; und
einen Antriebsmechanismus (56), der dazu ausgebildet ist, den Schieberkörper (52) durch die Halterungsstange (54) anzutreiben,
**dadurch gekennzeichnet , dass** der Antriebsmechanismus (56) aufweist:
eine bewegliche Wellenanordnung (75), die sich in einer zweiten Richtung im Wesentlichen senkrecht zur ersten Richtung erstreckt, und so ausgebildet ist, dass sie sich in der zweiten Richtung hin- und herbewegen kann,
eine erste Nockenanordnung (82, 106), welche die bewegliche Wellenanordnung (55) mit der Halterungsstange (54) verbindet, und einen Abschnitt (106A) aufweist, der dazu ausgebildet ist, die Hin- und Herbewegung der beweglichen Wellenanordnung (75) in der zweiten Richtung in eine Hin- und Herbewegung der Halterungsstange (54) in der ersten Richtung umzuwandeln, und
einen Schwenkantrieb (80, 116), der dazu ausgebildet ist, die Halterungsstange (54) und den Schieberkörper (52) um eine Zentrumsachse der beweglichen Wellenanordnung als Zentrum zu verschwenken.

2. Einrichtung nach Anspruch 1, bei welcher der Antriebsmechanismus (56) **dadurch gekennzeichnet ist, dass** weiterhin vorgesehen sind:
ein Kolbenkopf (102, 103), der mit der beweglichen Wellenanordnung (75) verbunden ist;
ein Zylinder (74), welcher den Kolbenkopf (102, 103) aufnimmt, und hierbei einen ersten und einen zweiten luftdichten Raum (94A, 94B) jeweils an einer Seite des Kolbenkopfes (102, 103) ausbildet; und
ein Mechanismus (GS), der dazu ausgebildet ist, selektiv ein Fluid dem ersten und zweiten luftdichten Raum (94A, 94B) zuzuführen, um den Kolbenkopf (102, 103) anzutreiben.

3. Einrichtung nach Anspruch 1,
**dadurch gekennzeichnet , dass** die erste Nockenanordnung (82, 106) eine erste Schrägführung (106A) und ein erstes Eingriffselement (82) aufweist, die auf der beweglichen Wellenanordnung (75) bzw. der Halterungsstange (54) so angeordnet sind, dass sie in Eingriff miteinander gelangen, um die Hin- und Herbewegung der beweglichen Wellenanordnung (75) in der zweiten Richtung in eine Hin- und Herbewegung der Halterungsstange (54) in der ersten Richtung umzuwandeln, und die erste Schrägführung (106A) schräg in Bezug auf die Zentrumsachse der beweglichen Wellenanordnung (75) angeordnet ist.

4. Einrichtung nach Anspruch 3,
**dadurch gekennzeichnet , dass** die erste Schrägführung (106A) einen Verzögerungsabschnitt (130A) aufweist, der einen verringerten Schrägstellwinkel an einem Ende entsprechend einem Ort für den Schieberkörper (52) zum Schließen der Durchlassöffnung (37) aufweist.

5. Einrichtung nach Anspruch 4,
**dadurch gekennzeichnet , dass** die erste Schrägführung (106A) weiterhin einen Verriegelungsabschnitt (130B) aufweist, der außerhalb des Verzögerungsabschnitts (130A) angeordnet ist, und eine Schrägstellung in entgegengesetzter Richtung aufweist.

6. Einrichtung nach Anspruch 1,
**dadurch gekennzeichnet , dass** der Schwenkantrieb (80, 116) so ausgebildet ist, dass er die Hin- und Herbewegung der beweglichen Wellenanordnung (75) in der zweiten Richtung in eine Schwenkbewegung der Halterungsstange (54) und des Schieberkörpers (52) umwandelt.

7. Einrichtung nach Anspruch 6,
**dadurch gekennzeichnet , dass** der Schwenkantrieb (80, 116) aufweist:
einen Kupplungsabschnitt (82, 106B), welcher die Halterungsstange (54) mit der beweglichen Wellenanordnung (75) kuppelt, und so ausgebildet ist, dass die Halterungsstange (54) zusammen mit der beweglichen Wellenanordnung (75) um die Zentrumsachse der beweglichen Wellenanordnung (75) als Zentrum gedreht wird;
eine zweite Nockenanordnung (80, 116), welche die bewegliche Wellenanordnung (75) mit einem Basisabschnitt (98) kuppelt, und einen Abschnitt (116B) aufweist, der so ausgebildet ist, dass er die Hin- und Herbewegung der beweglichen Wellenanordnung (75) in der zweiten Richtung in eine Drehbewegung der beweglichen Wellenanordnung (75) um die Zentrumsachse der beweglichen Wellenanordnung (75) als Zentrum umwandelt.

8. Einrichtung nach Anspruch 7,
**dadurch gekennzeichnet , dass** die zweite Nockenanordnung (80, 116) eine zweite Schrägführung (116B) und ein zweites Eingriffselement (80) aufweist, die auf dem Basisabschnitt (98) bzw. der beweglichen Wellenanordnung (75) so angeordnet sind, dass sie miteinander im Eingriff stehen, um die Hin- und Herbewegung der beweglichen Wellenanordnung (75) in der zweiten Richtung in eine Drehbewegung der beweglichen Wellenanordnung (75) um die Zentrumsachse der beweglichen Wellenanordnung (75) als Zentrum umzuwandeln, und die zweite Schrägführung (116B) schräg in Bezug auf die Zentrumsachse der beweglichen Wellenanordnung (75) angeordnet ist.

9. Einrichtung nach Anspruch 8,
**dadurch gekennzeichnet , dass** die erste Nockenanordnung (82, 106) eine erste Schrägführung (106A) und ein erstes Eingriffselement (82) aufweist, die auf der beweglichen Wellenanordnung (75) bzw. der Halterungsstange (54) angeordnet sind, so dass sie miteinander im Eingriff stehen, um die Hin- und Herbewegung der beweglichen Wellenanordnung (75) in der zweiten Richtung in eine Hin- und Herbewegung der Halterungsstange (54) in der ersten Richtung umzuwandeln, wobei die erste Schrägführung (106A) schräg in Bezug auf die Zentrumsachse der beweglichen Wellenanordnung (75) ausgebildet ist, und
die erste Nockenanordnung (82, 106) eine erste Linearführung (106B) aufweist, die parallel zur Zentrumsachse der beweglichen Wellenanordnung (75) und entsprechend zur zweiten Schrägführung (116B) vorgesehen ist, und die zweite Nockenanordnung (80, 116) eine zweite Linearführung (116A) aufweist, die parallel zur Zentrumsachse der beweglichen Wellenanordnung (75) vorgesehen ist, und entsprechend zur ersten Schrägführung (106A).

10. Einrichtung nach Anspruch 7,
**dadurch gekennzeichnet , dass** die bewegliche Wellenanordnung (75) eine innere Welle (78) und eine äußere Welle (76) aufweist, die koaxial angeordnet sind, um zusammen eine Hin- und Herbewegung und eine Drehbewegung durchzuführen,
wobei die erste Nockenanordnung (82, 106) eine erste Schrägführung (106A) und ein erstes Eingriffselement (82) aufweist, die an der äußeren Welle (76) bzw. der Halterungsstange (54) so angeordnet sind, dass sie in gegenseitigen Eingriff gelangen, um die Hin- und Herbewegung der beweglichen Wellenanordnung (75) in der zweiten Richtung in eine Hin- und Herbewegung der Halterungsstange (54) umzuwandeln, und die erste Schrägführung (106A) schräg in Bezug auf die Zentrumsachse der beweglichen Wellenanordnung (75) angeordnet ist, und
wobei die zweite Nockenanordnung (80, 116) eine zweite Schrägführung (116B) und ein zweites Eingriffselement (80) aufweist, die an dem Basisabschnitt (98) bzw. der inneren Welle (78) angeordnet sind, um miteinander in Eingriff zu stehen, um die Hin- und Herbewegung der beweglichen Wellenanordnung (75) in der zweiten Richtung in eine Drehbewegung der beweglichen Wellenanordnung (75) um die Zentrumsachse der beweglichen Wellenanordnung (75) als Zentrum umzuwandeln, und die zweite Schrägführung (116B) schräg in Bezug auf die Zentrumsachse der beweglichen Wellenanordnung (75) ausgebildet ist.

11. Einrichtung nach Anspruch 10,
**dadurch gekennzeichnet , dass** der Antriebsmechanismus (56) aufweist:
einen Kolbenkopf (102, 103), der mit der beweglichen Wellenanordnung (75) verbunden ist;
einen Zylinder, der den Kolbenkopf (102, 103), die innere Welle (78), und die äußere Welle (76) aufnimmt, und hierbei einen ersten und einen zweiten luftdichten Raum (94A, 94B) an einer der beiden Seiten des Kolbenkopfes (102, 1039 festlegt; und
einen Gaszufuhrmechanismus (GS), der dazu ausgebildet ist, wahlweise ein Gas dem ersten und dem zweiten, luftdichten Raum (94A, 94B) zuzuführen, um den Kolbenkopf (102, 103) anzutreiben.

12. Einrichtung nach Anspruch 11,
**dadurch gekennzeichnet , dass** der Gaszufuhrmechanismus (GS) einen Gaskanal (110) aufweist, der die innere Welle (78) und den Kolbenkopf (102, 103) in Axialrichtung durchdringt, und mit dem ersten, luftdichten Raum (94A) verbunden ist.

13. Einrichtung nach Anspruch 11,
**dadurch gekennzeichnet, dass** der Zylinder (74) so ausgebildet ist, dass er sich zusammen mit der Halterungsstange (54) und der beweglichen Wellenanordnung (75) um die Zentrumsachse der beweglichen Wellenanordnung (75) als Zentrum dreht.

14. Einrichtung nach Anspruch 1,
**dadurch gekennzeichnet , dass** die Halterungsstange (54) einen ersten und einen zweiten Abschnitt aufweist, die mit dem Schieberkörper (52) an entgegengesetzten Enden verbunden sind, und der Antriebsmechanismus (56) einen ersten und einen zweiten Abschnitt aufweist, die so angeordnet sind, dass sie dem ersten und zweiten Abschnitt der Halterungsstange (54) entsprechen.

15. Einrichtung nach Anspruch 14,
**dadurch gekennzeichnet , dass** der erste und der zweite Abschnitt des Antriebsmechanismus (56) miteinander durch ein Verstärkungsteil (72) verbunden sind.

16. Einrichtung nach Anspruch 1,
**dadurch gekennzeichnet , dass** der Schwenkantrieb einen Drehantrieb (140) aufweist, der so ausgebildet ist, dass er vereinigt die gesamte bewegliche Wellenanordnung (75) um die Zentrumsachse der beweglichen Wellenanordnung (75) als Zentrum dreht, um so die Halterungsstange (54) und den Schieberkörper (52) zu verschwenken.

17. Einrichtung nach Anspruch 1,
**dadurch gekennzeichnet , dass** das Vakuumbearbeitungssystem eine Wartungsöffnung (44) aufweist, die an einem Ort angeordnet ist, an welchem der Schieberkörper (52) selektiv innerhalb eines Drehbereiches dem Schieberkörper (52) zugewandt ist, um einen Wartungsvorgang bei der Absperrschiebervorrichtung durchzuführen, und
wobei die erste Nockenanordnung (82, 106) einen Abschnitt (106C) aufweist, der so ausgebildet ist, dass er eine Hin- und Herbewegung der beweglichen Wellenanordnung (75) in der zweiten Richtung in eine Hin- und Herbewegung der Halterungsstange (54) relativ zur Wartungsöffnung (44) umwandelt.

18. Einrichtung nach Anspruch 17,
**dadurch gekennzeichnet , dass** die erste Nockenanordnung (82, 106) eine erste Schrägführung (106A) und ein erstes Eingriffselement (82) aufweist, die in der beweglichen Wellenanordnung (75) bzw. der Halterungsstange (54) so angeordnet sind, dass sie miteinander in Eingriff gelangen, um die Hin- und Herbewegung der beweglichen Wellenanordnung (75) in der zweiten Richtung in eine Hin- und Herbewegung der Halterungsstange (54) in der ersten Richtung umzuwandeln, und die erste Schrägführung (106A) schräg in Bezug auf die Zentrumsachse der beweglichen Wellenanordnung (75) angeordnet ist, und
die erste Nockenanordnung (82, 106) weiterhin eine dritte Schrägführung (106C) aufweist, die mit der ersten Schrägführung (106A) so verbunden ist, dass ein Eingriff mit dem ersten Eingriffselement (82) erfolgt, um die Hin- und Herbewegung der beweglichen Wellenanordnung (75) in der zweiten Richtung in eine Hin- und Herbewegung der Halterungsstange (54) relativ zur Wartungsöffnung (44) umzuwandeln.

19. Einrichtung nach Anspruch 18,
**dadurch gekennzeichnet , dass** die erste und die dritte Schrägführung (106A, 106C) so angeordnet sind, dass eine U-Form oder eine V-Form ausgebildet wird.

20. Halbleiterbearbeitungssystem, bei welchem vorgesehen sind:
eine in Bezug auf den Druck einstellbare, gemeinsame Durchlasskammer (6), welche mehrere Seitenoberflächen aufweist;
eine erste und eine zweite Bearbeitungskammer (4), mit einstellbarem Druck, die mit zwei der mehreren Seitenoberflächen verbunden sind, und jeweils so ausgebildet sind, dass sie eine Halbleiterbearbeitung bei einem Zielgegenstand durchführen;
ein Transportmechanismus, der innerhalb der gemeinsamen Durchlasskammer (6) vorgesehen ist, um den Zielgegenstand in die erste und zweite Bearbeitungskammer (4) und aus dieser heraus zu transportieren; und
Absperrschiebereinrichtungen (12), die zwischen der gemeinsamen Durchlasskammer (6) und der ersten Bearbeitungskammer (4) und zwischen der gemeinsamen Durchlasskammer (6) und der zweiten Bearbeitungskammer (4) vorgesehen sind,
wobei jede der Absperrschiebereinrichtungen (12) aufweist
einen Schieberkörper (52), der dazu ausgebildet ist, eine Durchlassöffnung (37) zu öffnen und zu schließen, durch welche der Zielgegenstand hindurchgeht, und sich zu der Durchlassöffnung (37) hin und von dieser weg bewegen kann, durch eine Hin- und Herbewegung des Schieberkörpers (52) in einer ersten Richtung,
eine Halterungsstange (54), die mit dem Schieberkörper (52) verbunden ist, und sich in der ersten Richtung erstreckt, und
einen Antriebsmechanismus (56), der dazu ausgebildet ist, den Schieberkörper (52) durch die Halterungsstange (54) anzutreiben,
**dadurch gekennzeichnet, dass** der Antriebsmechanismus (56) eine bewegliche Wellenanordnung (75) aufweist, die sich in einer zweiten Richtung im Wesentlichen senkrecht zur ersten Richtung erstreckt, und so ausgebildet ist, dass sie in der zweiten Richtung hin- und her bewegt wird,
eine erste Nockenanordnung (82, 106), welche die bewegliche Wellenanordnung (75) mit der Halterungsstange (54) verbindet, und einen Abschnitt (106A) aufweist, der so ausgebildet ist, dass er die Hin- und Herbewegung der beweglichen Wellenanordnung (75) in der zweiten Richtung in eine Hin- und Herbewegung der Halterungsstange (54) in der ersten Richtung umwandelt, und
einen Schwenkantrieb (80, 116), der so ausgebildet ist, dass er die Halterungsstange (54) und den Schieberkörper (52) um eine Zentrumsachse der beweglichen Wellenanordnung (75) als Drehzentrum verschwenkt.

## Revendications

1. Appareil à robinet-vanne devant être proposé pour un orifice de transfert (37) à travers lequel un objet cible passe dans un système de traitement sous vide, l'appareil comprenant :
un corps de vanne (52) configuré pour ouvrir et fermer l'orifice de transfert (37) et pour.être déplacé vers et depuis l'orifice de transfert (37) par un mouvement de va-et-vient du corps du vanne (52) dans une première direction ;
une tige de support (54) reliée au corps de vanne (52) et s'étendant dans la première direction ; et
un mécanisme d'entraînement (56) configuré pour entraîner le corps de vanne (52), par l'intermédiaire de la tige de support (54),
**caractérisé en ce que** le mécanisme d'entraînement (56) comprend :
une structure d'arbre mobile (75) s'étendant dans une seconde direction sensiblement perpendiculaire à la première direction et configurée pour être actionnée en va-et-vient dans la seconde direction,
une première structure de came (82, 106) accouplant la structure d'arbre mobile (75) à la tige de support (54), et incluant une partie (106A) configurée pour convertir le mouvement de va-et-vient de la structure d'arbre mobile (75) dans la seconde direction en un mouvement de va-et-vient de la tige de support (54) dans la première direction, et
un entraînement à bascule (80, 116) configuré pour basculer la tige de support (54) et le corps de vanne (52) autour d'un axe central de la structure d'arbre mobile (75) servant de centre.

2. Appareil selon la revendication 1, dans lequel le mécanisme d'entraînement (56) est **caractérisé en ce qu'**il comprend de plus :
une tête de piston (102, 103) reliée à la structure d'arbre mobile (75) ;
un cylindre (74) accueillant la tête de piston (102, 103) tout en définissant des premier et second espaces hermétiques (94A, 94B), un de chaque côté de la tête de piston (102, 103) ; et
un mécanisme (GS) configuré pour fournir sélectivement un fluide dans les premier et second espaces hermétiques à l'air (94A, 94B) pour entraîner la tête de piston (102, 103).

3. Appareil selon la revendication 1, **caractérisé en ce que** la première structure de came (82, 106) comprend un premier guide oblique (106A) et un premier élément de mise en prise (82) respectivement disposés sur l'une et l'autre de la structure d'arbre mobile (75) et de la tige de support (54) pour venir en prise avec elles, afin de convertir le mouvement de va-et-vient de la structure d'arbre mobile (75) dans la seconde direction en un mouvement de va-et-vient de la tige de support (54) dans la première direction, et le premier guide oblique (106A) est incliné par rapport à l'axe central de la structure d'arbre mobile (75).

4. Appareil selon la revendication 3, **caractérisé en ce que** le premier guide oblique (106A) comprend une partie de décélération (130A) ayant un angle d'inclinaison moindre à une extrémité correspondant à une position dans laquelle le corps de vanne (52) ferme l'orifice de transfert (37).

5. Appareil selon la revendication 4, **caractérisé en ce que** le premier guide oblique (106A) comprend de plus une partie de verrouillage (130B) disposée à l'extérieur de la partie de décélération (130A) et inclinée à l'inverse.

6. Appareil selon la revendication 1, **caractérisé en ce que** l'entraînement à bascule (80, 116) est configuré pour convertir le mouvement de va-et-vient de la structure d'arbre mobile (75) dans la seconde direction en un mouvement de bascule de la tige de support (54) et du corps de vanne (52).

7. Appareil selon la revendication 6, **caractérisé en ce que** l'entraînement à bascule (80, 116) comprend :
une partie d'accouplement (82, 106B) accouplant la tige de support (54) à la structure d'arbre mobile (75), et configurée pour faire tourner la tige de support (54) en même temps que la structure d'arbre mobile (75) autour de l'axe central de la structure d'arbre mobile (75) servant de centre ;
une seconde structure de came (80, 116) accouplant la structure d'arbre mobile (75) à une partie de base (98), et incluant une partie (116B) configurée pour convertir le mouvement de va-et-vient de la structure d'arbre mobile (75) dans la seconde direction en un mouvement de rotation de la structure d'arbre mobile (75) autour de l'axe central de la structure d'arbre mobile (75) servant de centre.

8. Appareil selon la revendication 7, **caractérisé en ce que** la seconde structure de came (80, 116) comprend un deuxième guide oblique (116B) et un second élément de misé en prise (80) respectivement disposés sur l'une et l'autre de la partie de base (98) et de la structure d'arbre mobile (75) pour venir en prise l'une avec l'autre, afin de convertir le mouvement de va-et-vient de la structure d'arbre mobile (75) dans la seconde direction en un mouvement de rotation de la structure d'arbre mobile (75) autour de l'axe central de la structure d'arbre mobile (75) servant de centre, et le deuxième guide oblique (116B) est incliné par rapport à l'axe central de la structure d'arbre mobile (75).

9. Appareil selon la revendication 8, **caractérisé en ce que** la première structure de came (82, 106) comprend un premier guide oblique (106A) et un premier élément de mise en prise (82) respectivement disposés sur l'une et l'autre de la structure d'arbre mobile (75) et de la tige de support (54) pour venir en prise avec elles, afin de convertir le mouvement de va-et-vient de la structure d'arbre mobile (75) dans la seconde direction en un mouvement de va-et-vient de la tige de support (54) dans la première direction, et le premier guide oblique (106A) est incliné par rapport à l'axe central de la structure d'arbre mobile (75), et
dans lequel la première structure de came (82, 106) comprend un premier guide linéaire (106B) disposé parallèlement à l'axe central de la structure d'arbre mobile (75) et de manière correspondante au deuxième guide oblique (116B), et la seconde structure de came (80, 116) comprend un deuxième guide linéaire (116A) disposé parallèlement à l'axe central de la structure d'arbre mobile (75) et de manière correspondante au premier guide oblique (106A).

10. Appareil selon la revendication 7, **caractérisé en ce que** la structure d'arbre mobile (75) comprend un arbre interne (78) et un arbre externe (76) disposés de manière coaxiale pour réaliser d'un seul tenant un mouvement de va-et-vient et un mouvement de rotation,
dans lequel la première structure de came (82, 106) comprend un premier guide oblique (106A) et un premier élément de mise en prise (82) respectivement disposés sur l'un et l'autre de l'arbre externe (76) et de la tige de support (54) pour venir en prise avec eux, afin de convertir le mouvement de va-et-vient de la structure d'arbre mobile (75) dans la seconde direction en un mouvement de va-et-vient de la tige de support (54) dans la première direction, et le premier guide oblique (106A) est incliné par rapport à l'axe central de la structure d'arbre mobile (75), et
dans lequel la seconde structure de came (80, 116) comprend un deuxième guide oblique (116B) et un second élément de mise en prise (80) respectivement disposés sur l'un et l'autre de la partie de base (98) et de l'arbre interne (78) pour venir en prise l'un avec l'autre, afin de convertir le mouvement de va-et-vient de la structure d'arbre mobile (75) dans la seconde direction en un mouvement de rotation de la structure d'arbre mobile (75) autour de l'axe central de la structure d'arbre mobile (75) servant de centre, et le deuxième guide oblique (116B) est incliné par rapport à l'axe central de la structure d'arbre mobile (75).

11. Appareil selon la revendication 10, **caractérisé en ce que** le mécanisme d'entraînement (56) comprend :
une tête de piston (102, 103) reliée à la structure d'arbre mobile (75) ;
un cylindre (74) accueillant la tête de piston (102, 103), l'arbre interne (78), et l'arbre externe (76) tout en définissant des premier et second espaces hermétiques à l'air (94A, 94B), un de chaque côté de la tête de piston (102, 103) ; et
un mécanisme d'alimentation en gaz (GS) configuré pour fournir sélectivement un gaz dans les premier et second espaces hermétiques à l'air (94A, 94B) pour entraîner la tête de piston (102, 103).

12. Appareil selon la revendication 11, **caractérisé en ce que** le mécanisme d'alimentation en gaz (GS) comprend un passage de gaz (110) pénétrant dans l'arbre interne (78) et la tête de piston (102, 103) dans une direction axiale et relié au premier espace hermétique à l'air (94A).

13. Appareil selon la revendication 11, **caractérisé en ce que** le cylindre (74) est configuré pour tourner en même temps que la tige de support (54) et la structure d'arbre mobile (75) autour de l'axe central de la structure d'arbre mobile (75) servant de centre.

14. Appareil selon la revendication 1, **caractérisé en ce que** la tige de support (54) comprend des première et seconde parties respectivement reliées au corps de vanne (52) près d'extrémités opposées de celui-ci, et le mécanisme d'entraînement (56) comprend des première et seconde parties respectivement disposées pour correspondre aux première et seconde parties de la tige de support (54).

15. Appareil selon la revendication 14, **caractérisé en ce que** les première et seconde parties du mécanisme d'entraînement (56) sont reliées entre elles par un élément de renfort (72).

16. Appareil selon la revendication 1, **caractérisé en ce que** l'entraînement à bascule comprend un entraînement de rotation (140) configuré pour faire tourner d'un seul tenant l'entiereté de la structure d'arbre mobile (75) autour de l'axe central de la structure d'arbre mobile (75) servant de centre, afin de basculer la tige de support (54) et le corps de vanne (52).

17. Appareil selon la revendication 1, **caractérisé en ce que** le système de traitement sous vide comprend un orifice d'entretien (44), disposé au niveau d'une position à laquelle le corps de vanne (52) fait face sélectivement à l'intérieur d'une plage de rotation du corps de vanne (52), pour réaliser une opération d'entretien sur l'appareil à robinet-vanne, et
dans lequel la première structure de came (82, 106) comprend une partie (106C) configurée pour convertir le mouvement de va-et-vient de la structure d'arbre mobile (75) dans la seconde direction en un mouvement de va-et-vient de la tige de support (54) par rapport à l'orifice d'entretien (44).

18. Appareil selon la revendication 17, **caractérisé en ce que** la première structure de came (82, 106) comprend un premier guide oblique (106A) et un premier élément de mise en prise (82) respectivement disposés sur l'une et l'autre de la structure d'arbre mobile (75) et de la tige de support (54) pour venir en prise l'une avec l'autre, afin de convertir le mouvement de va-et-vient de la structure d'arbre mobile (75) dans la seconde direction en un mouvement de va-et-vient de la tige de support (54) dans la première direction, et le premier guide oblique (106A) est incliné par rapport à l'axe central de la structure d'arbre mobile (75), et
dans lequel la première structure de came (82, 106) comprend de plus un troisième guide oblique (106C) relié au premier guide oblique (106A) pour venir en prise avec le premier élément de mise en prise (82), afin de convertir le mouvement de va-et-vient de la structure d'arbre mobile (75) dans la seconde direction en un mouvement de va-et-vient de la tige de support (54) par rapport à l'orifice d'entretien (44).

19. Appareil selon la revendication 18, **caractérisé en ce que** les premier et troisième guides obliques 106A, 106C sont disposés pour réaliser une forme en U ou une forme en V.

20. Système de traitement à semi-conducteur comprenant :
une chambre de transfert commune à pression réglable (6) ayant une pluralité de surfaces latérales ;
des première et seconde chambres de traitement à pression ajustable (4) reliées à deux de la pluralité de surfaces latérales et chacune configurée pour réaliser un traitement à semi-conducteur sur un objet cible ;
un mécanisme de transfert disposé à l'intérieur de la chambre de transfert commune (6) pour transférer l'objet cible dans et depuis les première et seconde chambres de traitement (4) ; et
des appareils à robinet-vanne (12) respectivement disposés entre la chambre de transfert commune (6) et la première chambre de traitement (4) et entre la chambre de transfert commune (6) et la seconde chambre de traitement (4),
dans lequel chacun des appareils à robinet-vanne (12) comprend :
un corps de vanne (52) configuré pour ouvrir et fermer un orifice de transfert (37) à travers lequel l'objet cible passe, et pour être déplacé vers et depuis l'orifice de transfert (37) par un mouvement de va-et-vient du corps de vanne (52) dans une première direction,
une tige de support (54) reliée au corps de vanne (52) et s'étendant dans la première direction, et
un mécanisme d'entraînement (56) configuré pour entraîner le corps de vanne (52), par l'intermédiaire de la tige de support (54), et
**caractérisé en ce que** le mécanisme d'entraînement (56) comprend :
une structure d'arbre mobile (75) s'étendant dans une seconde direction sensiblement perpendiculaire à la première direction et configurée pour être actionnée en va-et-vient dans la seconde direction,
une première structure de came (82, 106) accouplant la structure d'arbre mobile (75) à la tige de support (54), et incluant une partie (106A) configurée pour convertir le mouvement de va-et-vient de la structure d'arbre mobile (75) dans la seconde direction en un mouvement de va-et-vient de la tige de support (54) dans la première direction, et
un entraînement à bascule (80, 116) configuré pour basculer la tige de support (54) et le corps de vanne (52) autour d'un axe central de la structure d'arbre mobile (75) servant de centre.
